# EUROPEAN PATENT SPECIFICATION

(11) **EP 4 191 860 B1**
(45) Date of publication and mention of the grant of the patent: **07.10.2026**
(21) Application number: 22180095.6
(22) Date of filing: 21.06.2022
(51) Int. Cl.: H02M 3/335

(54) **DC/DC CONVERTER WITH THREE-LEVEL RECTIFICATION**
GLEICHSTROM-WANDLER MIT DREISTUFIGEM GLEICHRICHTER
CONVERTISSEUR CC/CC AVEC RECTIFICATION À TROIS NIVEAUX

(30) Priority: 02.12.2021 CN 202111463234
(43) Date of publication of application: 07.06.2023
(73) Proprietor: DELTA ELECTRONICS (SHANGHAI) CO., LTD, Shanghai 201209 (CN)
(72) Inventor: Zhang, Chi, Apex, NC, 27502 (US); Jia, Minli, Shanghai, 201209 (CN); Sun, Hao, Shanghai, 201209 (CN); Zhang, Jinfa, Shanghai, 201209 (CN); Barbosa, Peter Mantovanelli, Cary, NC, 27519 (US)
(74) Representative: Uexküll & Stolberg

(56) References cited:
- CN-A- 111 224 553
- YANG DONGJIANG ET AL: "High-Efficiency Bidirectional Three-Level Series-Resonant Converter With Buck-Boost Capacity for High-Output Voltage Applications", IEEE TRANSACTIONS ON TRANSPORTATION ELECTRIFICATION, IEEE, vol. 7, no. 3, 28 January 2021 (2021-01-28), pages 969 - 982, XP011873101, DOI: 10.1109/TTE.2021.3055208

## Description

### FIELD OF THE INVENTION

The present disclosure relates to a DC/DC converter, and more particularly to a three-level rectification DC/DC converter.

### BACKGROUND OF THE INVENTION

Low-voltage DC/DC converter, bidirectional OBC (on-board charger), and traction inverter are three main power conversion units. The OBC works as an energy conversion unit between AC power and DC power to supply power for power battery, and thus the OBC is necessary in the configuration of the electric vehicle. Recently, as the endurance of the electric vehicle keeps increasing, the battery voltage is changing from the conventional battery voltage of 400V to 800V, and the charging for the OBC is changing from single-phase charging to three-phase charging. Accordingly, the rectification voltage from AC power to DC power would reach 800V. Therefore, the primary and secondary circuits of the DC/DC converter would both relate to the applications with 800V.

As the conventional component with the withstand voltage of 650V can't be used, the SiC component with the withstand voltage of 1200 may be used instead. However, the cost is higher, and the high dv/dt caused by the SiC component may lead to EMI (electromagnetic interference) problem. In addition, although the wide-bandgap semiconductor device (GaN) is regarded as the development trend of power devices in the future, it is hard to be directly applied in the high-voltage (800V) work environment due to its limited withstand voltage. The multi-level technique can be utilized to overcome the said limitation, to expand the development and application of actual products.

With regard to applications with wide output voltage range in actual engineering, to meet the needs of high efficiency and high output voltage gain, the PWM (pulse width modulation) control with fixed frequency based on dual-active-bridge circuit and the resonant soft-switching control with variable frequency based on LLC circuit are usually used.

For the dual-active-bridge circuit, the multiple phase shift technique is taken to realize the zero-voltage switching of switches under the wide output range condition. However, the control therefor is relatively complicated, and the high turn-off current may cause high turn-off stress and EMI problem.

For the LLC circuit, the variable frequency control is taken to allow all the switches to achieve zero voltage switching, and it is relatively easy to implement the variable frequency control. However, the LLC is unable to meet the bidirectional work requirement in actual applications.

YANG DONGJIANG et al.: "High-Efficiency Bidirectional Three-Level SeriesResonant Converter With Buck-Boost Capacitor for High-Output VoltageApplications", IEEE TRANSACTIONS ON TRANSPORTATION ELECTRIFICATION, IEEE, vol. 7, no. 3, 28 January 2021, pages 969-982, XP011873101, DOI:10.1109/TTE.2021.3055208, relates to improvements regarding the efficiency and power density of electronic vehicles, battery packs with higher voltage levels. Discussed are conventional battery charger designs based on two-level topologiesand low-voltage rating switches. Therefore, this document proposes a bidirectionalbuck-boost three-level series-resonant converter (BBTL-SRC) for high-outputvoltage applications. The voltage stress of switches is reduced to only half of the output voltage, so the low-voltage rating switches with lower losses and costs canbe used. In addition, the phase-shift and pulse-width modulation strategies aredesigned to realize buck and boost conversion. All switches can achieve zerovoltage switching and the reactive current in resonant tank decreases significantly. Hence, the switching and conduction losses are reduced and efficiency is optimized. The operation principles and characteristics are analyzed in detail and design considerations are provided.

CN 111 224 553 A discloses an improved bidirectional half-bridge three-levelLLC direct-current converter and a synchronous control method thereof. When theswitching frequency is greater than the resonant frequency, the synchronous control method is adopted, that is, the driving signals of a power supply Vin side and a power supply Vo side are synchronous; and when the switching frequency is less than or equal to the resonant frequency, an improved synchronous control method is adopted, that is, the driving signal on the power supply Vin side is unchanged, the frequency of the driving signal on the power supply Vo side is equal to that of the power supply Vin side, but the conduction time of the driving signal is kept constant and is always half of the resonant period. The topological structure of the bidirectional half-bridge three-level LLC resonant converter is symmetrical, and theforward working principle and the reverse working principle of the circuit are the same. The converter adopts variable frequency control, and the output voltage can be controlled only by changing the switching frequency. The converter improves the voltage grade and the power grade of the circuit, the input side switching tube realizes soft switching in a full load range, and the output side uses the switching tube to replace a traditional diode, so that the conduction loss can be effectively reduced.

Therefore, there is a need of providing a three-level rectification DC/DC converter to overcome the drawbacks of conventional technologies.

### SUMMARY OF THE INVENTION

The present disclosure provides a three-level rectification DC/DC converter which has the characteristic of a resonant circuit and can meet the bidirectional work requirement. In addition, the three-level rectification DC/DC converter has the characteristic of storing energy through short-circuiting the secondary circuit thereof, thereby achieving the output with high voltage gain.

In accordance with an aspect of the present disclosure, a three-level rectification DC/DC converter is provided. The three-level rectification DC/DC converter includes a primary circuit, a resonant tank circuit, and a secondary circuit. The primary circuit receives an input voltage and includes a plurality of primary switches. The resonant tank circuit includes a resonant inductor, a resonant capacitor, and a transformer. A first primary terminal and a second primary terminal of the resonant tank circuit are coupled to the primary circuit. A primary winding of the transformer is coupled between the first and second primary terminals. A secondary winding of the transformer is coupled between a first secondary terminal and a second secondary terminal of the resonant tank circuit. A voltage between the first and second primary terminals is a first voltage, and a voltage between the first and second secondary terminals is a second voltage. The secondary circuit includes two clamping switches, a switch bridge arm, and a capacitor bridge arm. The switch bridge arm includes a first secondary switch, a second secondary switch, a third secondary switch, and a fourth secondary switch sequentially connected in series. The two clamping switches are connected in series between a node between the first and second secondary switches and a node between the third and fourth secondary switches. A node between the second and third secondary switches is connected to the first secondary terminal. The capacitor bridge arm includes a first output capacitor and a second output capacitor connected in series. A node between the first and second output capacitors is connected to a node between the two clamping switches and the second secondary terminal. Two terminals of the capacitor bridge arm are connected to two terminals of the switch bridge arm, and a voltage between the two terminals of the capacitor bridge arm is an output voltage.

According to the invention, the first voltage is a square wave, and if the first and fourth secondary switches are maintained in an off state during a diode rectification mode, the second secondary switch is switched from the off state to an on state at a falling edge in a period of the first voltage and is in the on state for a preset time length after the falling edge, and the third secondary switch is switched from the off state to the on state at a rising edge in the period of the first voltage and is in the on state for the preset time length after the rising edge, wherein the first voltage is a square wave.

### BRIEF DESCRIPTION OF THE DRAWINGS

FIG. 1 is a schematic circuit diagram illustrating a three-level rectification DC/DC converter according to an embodiment of the present disclosure;
FIG. 2 schematically shows an equivalent circuit of the three-level rectification DC/DC converter of FIG. 1;
FIG. 3A and FIG. 3B show variants of the three-level rectification DC/DC converter of FIG. 1;
FIG. 4 is a schematic oscillogram showing the key waveforms of the three-level rectification DC/DC converter of FIG. 1;
FIGS. 5A to 5F show the working state of the three-level rectification DC/DC converter of FIG. 1 in one period of the secondary switches;
FIG. 6A shows an equivalent circuit of the three-level rectification DC/DC converter of FIG. 1 while the first voltage is at a high level and the secondary switches being turned on positively;
FIG. 6B shows an equivalent circuit of the three-level rectification DC/DC converter of FIG. 1 while the first voltage is at a low level and the secondary switches being turned on positively;
FIG. 7 is a schematic oscillogram showing the key waveforms of the three-level rectification DC/DC converter of FIG. 1 while applying complete synchronous rectification to the secondary switches;
FIG. 8A is a schematic block diagram illustrating the variable frequency control applied to the three-level rectification DC/DC converter of FIG. 1;
FIG. 8B is a schematic block diagram illustrating the fixed-frequency control applied to the three-level rectification DC/DC converter of FIG. 1;
FIG. 9 schematically shows a specific implementation of the resonant tank circuit of FIG. 1;
FIG. 10 schematically shows a specific implementation of the primary circuit of FIG. 1;
FIG. 11 is a schematic oscillogram showing the key waveforms of the three-level rectification DC/DC converter of FIG. 10;
FIG. 12 is a schematic oscillogram showing the key waveforms of the three-level rectification DC/DC converter of FIG. 10 while applying complete synchronous rectification to the secondary switches;
FIG. 13 schematically shows another specific implementation of the primary circuit of FIG. 1;
FIG. 14 is a schematic oscillogram showing the key waveforms of the three-level rectification DC/DC converter of FIG. 13; and
FIG. 15 is a schematic oscillogram showing the key waveforms of the three-level rectification DC/DC converter of FIG. 13 while applying complete synchronous rectification to the secondary switches.

### DETAILED DESCRIPTION OF THE PREFERRED EMBODIMENT

The present disclosure will now be described more specifically regarding the following embodiments. It is to be noted that the following descriptions of preferred embodiments of this disclosure are presented herein for purpose of illustration and description only. It is not intended to be exhaustive or to be limited to the precise form disclosed.

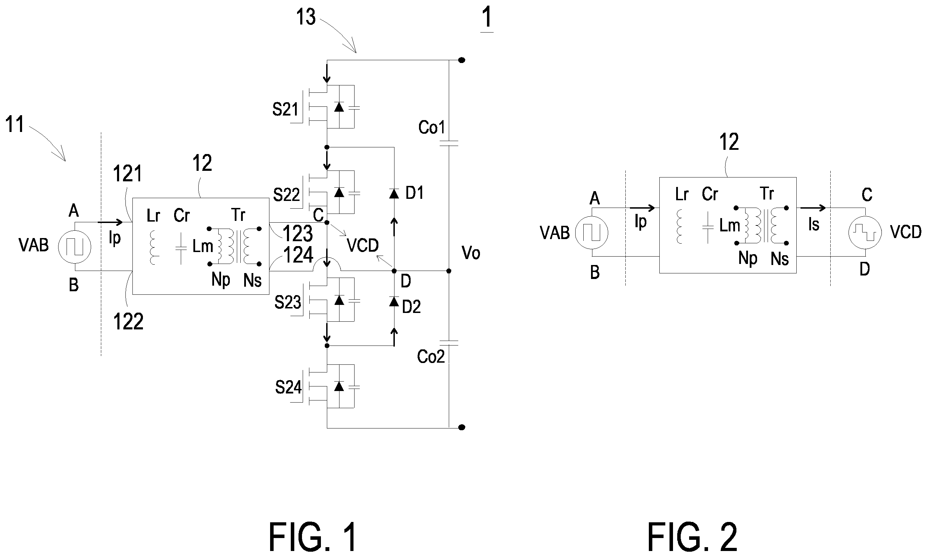

FIG. 1 is a schematic circuit diagram illustrating a three-level rectification DC/DC converter according to an embodiment of the present disclosure, and FIG. 2 schematically shows an equivalent circuit of the three-level rectification DC/DC converter of FIG. 1. As shown in FIG. 1 and FIG. 2, the three-level rectification DC/DC converter 1 includes a primary circuit 11, a resonant tank circuit 12, and a secondary circuit 13. The three-level rectification DC/DC converter 1 has the characteristic of resonant circuit and can meet the bidirectional work requirement.

The primary circuit 11 receives an input voltage Vin and includes a plurality of primary switches, and the primary circuit 11 is configured to provide a first voltage VAB. It is noted that the primary circuit 11 is represented by a voltage source which provides the first voltage VAB in this embodiment since the actual implementation of the primary circuit 11 is not limited. The specific implementation of the primary circuit 11 would be exemplified in the following descriptions.

The resonant tank circuit 12 includes a resonant inductor Lr, a resonant capacitor Cr, and a transformer Tr. A first primary terminal 121 and a second primary terminal 122 of the resonant tank circuit 12 are coupled to the primary circuit 11. A primary winding Np of the transformer Tr is coupled between the first primary terminal 121 and the second primary terminal 122. A secondary winding Ns of the transformer Tr is coupled between a first secondary terminal 123 and a second secondary terminal 124 of the resonant tank circuit 12. The voltage between the first primary terminal 121 and the second primary terminal 122 is the first voltage VAB, and the voltage between the first secondary terminal 123 and the second secondary terminal 124 is a second voltage VCD. In FIG. 1 and FIG. 2, Ip is the primary current, and Is is the secondary current.

The secondary circuit 13 includes two clamping switches D1 and D2, a switch bridge arm, and a capacitor bridge arm. The switch bridge arm includes a first secondary switch S21, a second secondary switch S22, a third secondary switch S23, and a fourth secondary switch S24 sequentially connected in series. The two clamping switches D1 and D2 are connected in series between a node between the first secondary switch S21 and the second secondary switch S22 and a node between the third secondary switch S23 and the fourth secondary switch S24. A node C between the second secondary switch S22 and the third secondary switch S23 is connected to the first secondary terminal 123. The capacitor bridge arm includes a first output capacitor Co1 and a second output capacitor Co2 connected in series. A node between the first output capacitor Co1 and the second output capacitor Co2 is connected to a node D between the two clamping switches D1 and D2 and the second secondary terminal 124. Two terminals of the capacitor bridge arm are connected to two terminals of the switch bridge arm respectively, and the voltage between the two terminals of the capacitor bridge arm is an output voltage Vo.

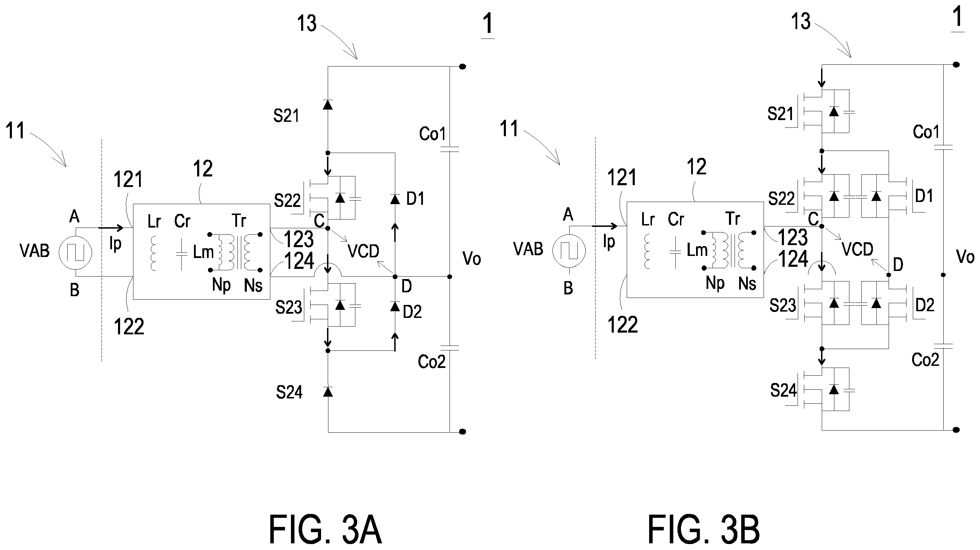

In the embodiment shown in FIG. 1, the first secondary switch S21, the second secondary switch S22, the third secondary switch S23, and the fourth secondary switch S24 are all active switches. In another embodiment, as exemplified in FIG. 3A, the first secondary switch S21 and the fourth secondary switch S24 may be a first diode and a second diode respectively. An anode and a cathode of the first diode are coupled to the second secondary switch S22 and the first output capacitor Co1 respectively. An anode and a cathode of the second diode are coupled to the second output capacitor Co2 and the third secondary switch S23 respectively.

In addition, in the embodiment shown in FIG. 1, the clamping switches D1 and D2 are a third diode and a fourth diode respectively. An anode and a cathode of the third diode are coupled to a cathode of the fourth diode and a node between the first secondary switch S21 and the second secondary switch S22 respectively. An anode of the fourth diode is coupled to a node between the third secondary switch S23 and the fourth secondary switch S24. In another embodiment, as exemplified in FIG. 3B, the clamping switches D1 and D2 may be active switches.

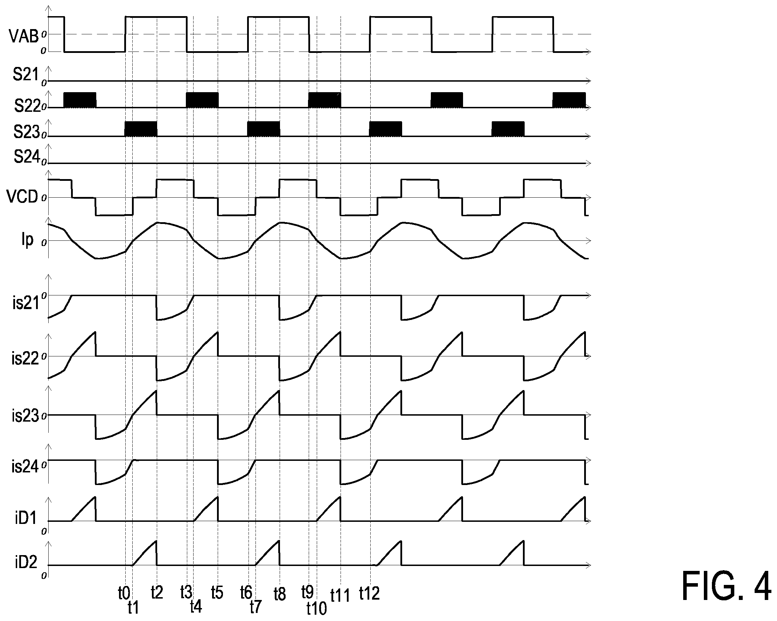

FIG. 4 is a schematic oscillogram showing the key waveforms of the three-level rectification DC/DC converter of FIG. 1. In FIG. 4, S21, S22, S23, and S24 represent the driving signals of the first secondary switch S21, the second secondary switch S22, the third secondary switch S23, and the fourth secondary switch S24 respectively; is21, is22, is23, and is24 represent the currents flowing through the first secondary switch S21, the second secondary switch S22, the third secondary switch S23, and the fourth secondary switch S24 respectively; and iD1 and iD2 represent the currents flowing through the clamping switches D1 and D2 respectively. As shown in FIG. 4, in any two consecutive periods of the first voltage VAB, the second secondary switch S22 is in an on state for a preset time length after the falling edge in the period of the first voltage VAB, and the third secondary switch S23 is in an on state for the preset time length after the rising edge in the period of the first voltage VAB. The first secondary switch S21 and the fourth secondary switch S24 are in diode rectification mode and are maintained in an off state. The second secondary switch S22 and the third secondary switch S23 have the same switching frequency equal to the frequency of the first voltage VAB. The phases of the second secondary switch S22 and the third secondary switch S23 are out of phase by 180 degrees with respect to each other. Further, all the secondary switches in secondary circuit 13 can be turned on with zero voltage switching. The said preset time length is obtained based on the input voltage Vin and the output voltage Vo. By controlling the preset time length, the duty ratio of each secondary switch can be adjusted, and the gain of the output voltage Vo can be controlled. In addition, the first voltage VAB is a square wave which is at a high level in one-half period and at a low level in the other half period, where the high level and the low level may be equal to +VAB/2 and -VAB/2 respectively, or equal to +VAB and 0 respectively.

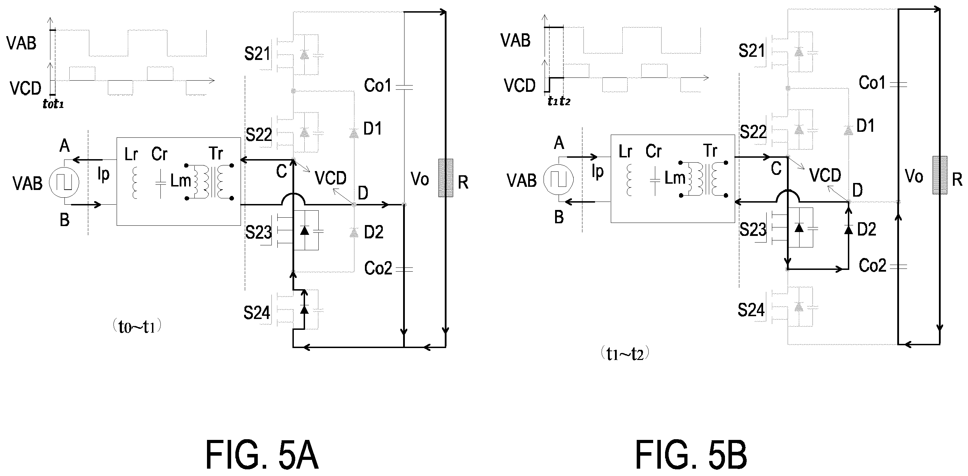

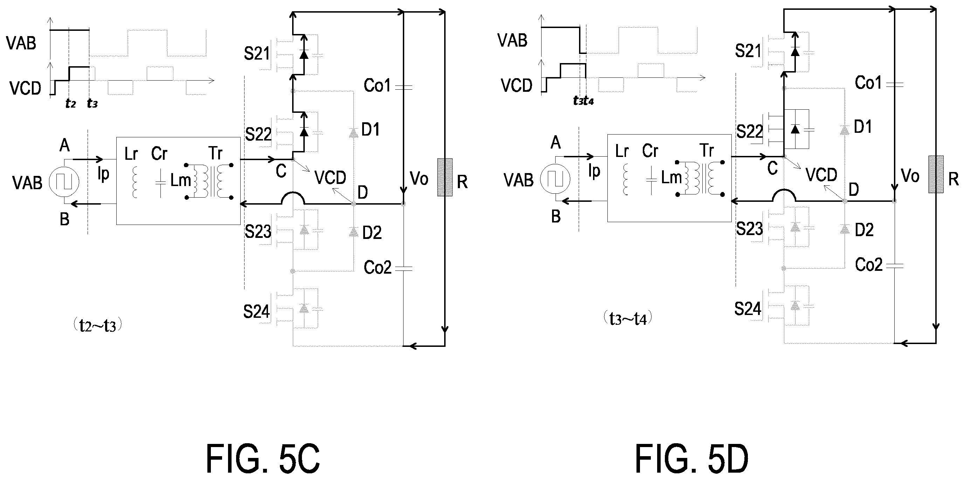

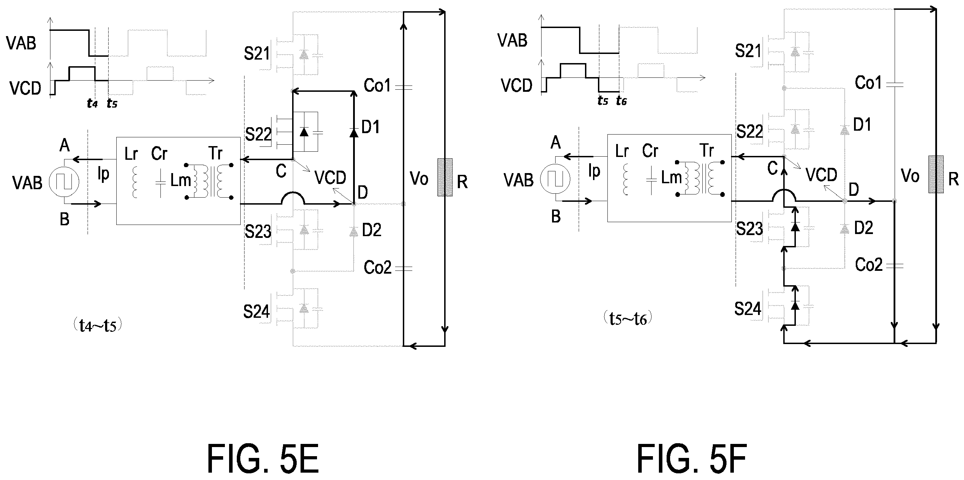

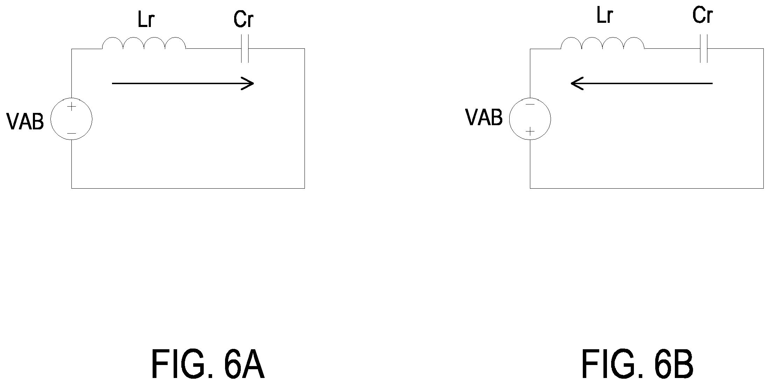

In FIG. 4, the duration from time t0 to t6 is regarded as one period of the secondary switches. FIGS. 5A to 5F show the working state of the three-level rectification DC/DC converter of FIG. 1 in one period. In specific, FIGS. 5A to 5F show the switching state and the current flowing direction of the three-level rectification DC/DC converter 1 within one period. The duration from time t1 to t2 (FIG. 5B) and the duration from time t4 to t5 (FIG. 5E) respectively correspond to the durations of the third secondary switch S23 and the second secondary switch S22 being turned on positively. FIGS. 5B and 5E show the corresponding working states of the three-level rectification DC/DC converter 1. The equivalent circuit of the three-level rectification DC/DC converter 1 during the duration from time t1 to t2 is shown in FIG. 6A. The equivalent circuit of the three-level rectification DC/DC converter 1 during the duration from time t4 to t5 is shown in FIG. 6B. From FIGS. 5B, 5E, 6A, and 6B, it can be seen that the secondary circuit 13 is equivalent to be in a short-circuit state when the third secondary switch S23 and the second secondary switch S22 are turned on positively. At this time, the energy is stored in the resonant inductor Lr through the first voltage VAB, which prepares for the high-gain energy output in the next duration.

From the above descriptions, in the three-level rectification DC/DC converter 1 of the present disclosure, through controlling the four secondary switches, the energy is stored in the resonant inductor Lr during the operating process, thereby achieving the high-gain voltage output.

In an embodiment, to further improve the work efficiency of the three-level rectification DC/DC converter 1, the secondary switches may be controlled with synchronous rectification. Namely, the secondary switch is driven during the current flowing reversely therethrough, thereby reducing the conduction loss of the secondary switches.

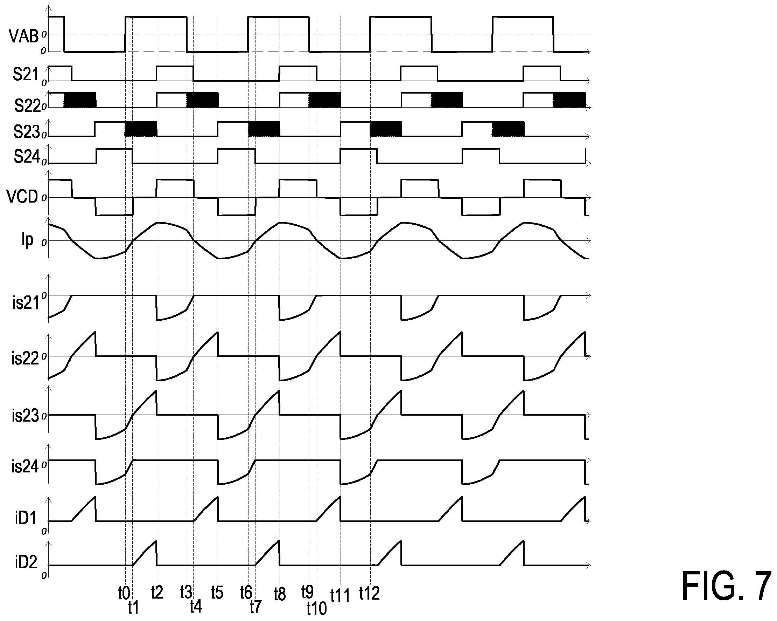

FIG. 7 is a schematic oscillogram showing the key waveforms of the three-level rectification DC/DC converter of FIG. 1 while applying complete synchronous rectification to the secondary switches. As shown in FIG. 7, while applying the complete synchronous rectification, in addition to the durations of being in the on state shown in FIG. 4, the first secondary switch S21, the second secondary switch S22, the third secondary switch S23, and the fourth secondary switch S24 are further in the on state during all durations within the duration of the currents flowing reversely through the first secondary switch S21, the second secondary switch S22, the third secondary switch S23, and the fourth secondary switch S24 respectively. In this embodiment, the driving signals of the second secondary switch S22 and the third secondary switch S23 are complementary and have the same duty ratio of 50%. A phase difference between the driving signals of the first secondary switch S21 and the fourth secondary switch S24 is 180 degrees, and a phase difference between the driving signals of the second secondary switch S22 and the third secondary switch S23 is 180 degrees.

In addition, depending on whether the switching frequency of primary switches is variable, the control for the three-level rectification DC/DC converter 1 of the present disclosure may be divided into a variable frequency control and a fixed-frequency control.

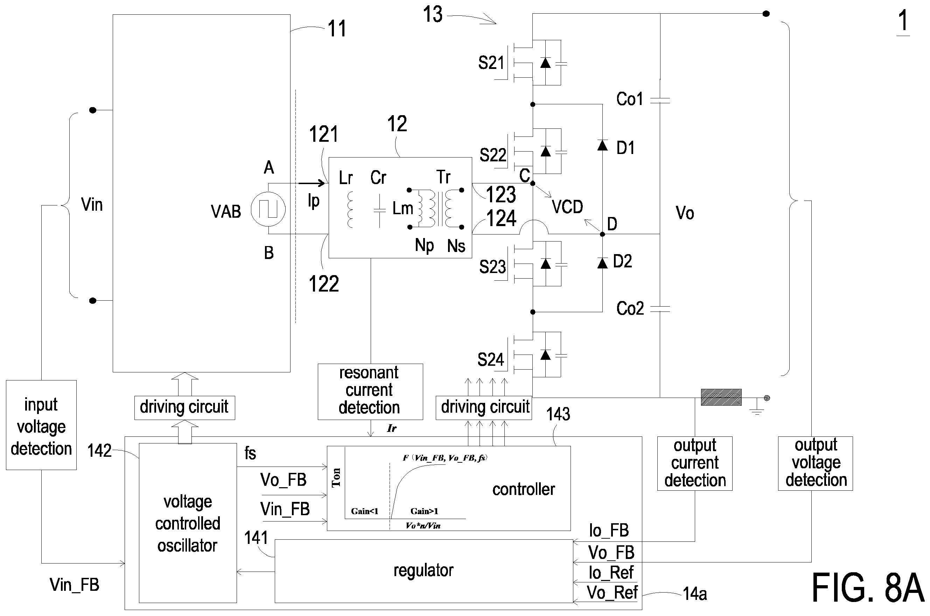

FIG. 8A is a schematic block diagram illustrating the variable frequency control applied to the three-level rectification DC/DC converter of FIG. 1. While applying the variable frequency control, as shown in FIG. 8A, the three-level rectification DC/DC converter 1 further includes a control module 14a. The control module 14a is configured to acquire an input voltage signal Vin_FB, an output voltage signal Vo_FB, and an output current signal Io_FB reflecting the input voltage Vin, the output voltage Vo, and the output current Io respectively through detection, and to control the operation of all the primary and secondary switches. The control module 14a includes a regulator 141, and the regulator 141 generates a regulating signal according to the output voltage signal Vo_FB, the output current signal Io_FB, an output reference voltage Vo_ref, and an output reference current Io_ref. In this embodiment, the control module 14a further includes a voltage-controlled oscillator 142 and a controller 143. The voltage-controlled oscillator 142 is coupled to the regulator 141 and generates a switching frequency fs of all the primary switches according to the regulating signal. The controller 143 is coupled to the voltage-controlled oscillator 142, and generates an on-time Ton of all the secondary switches according to the input voltage signal Vin_FB, the output voltage signal Vo_FB, and the switching frequency fs of all the primary switches. When the turns ratio n of the transformer Tr is fixed, the relations among the on-time Ton of all the secondary switches, the input voltage Vin, the output voltage Vo and the switching frequency fs of all the primary switches are conformed with the curve shown in FIG. 8A. In actual applications, the on-time Ton of the secondary switches may be obtained through calculation or look-up table.

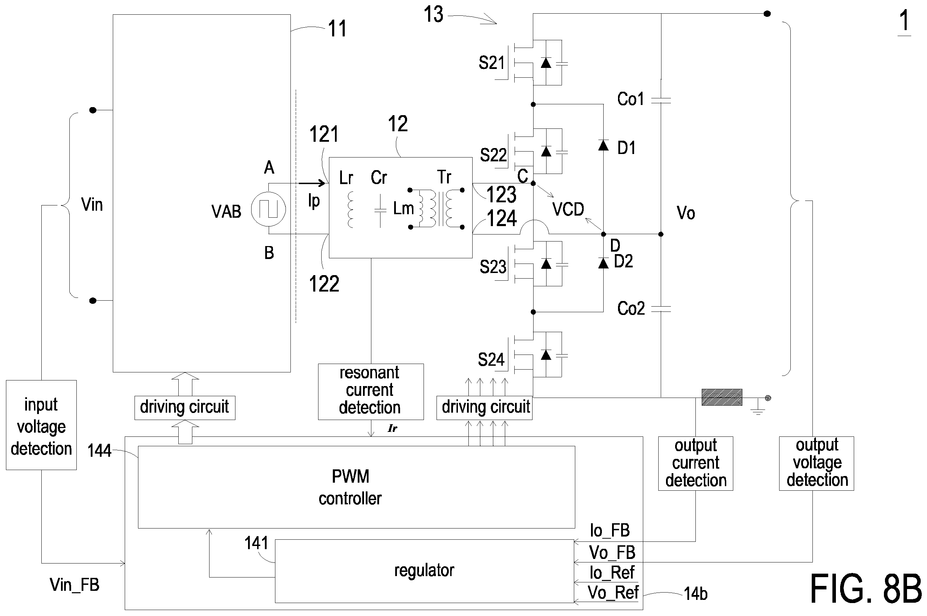

FIG. 8B is a schematic block diagram illustrating the fixed-frequency control applied to the three-level rectification DC/DC converter of FIG. 1. While applying the fixed-frequency control, the switching frequency fs of all the primary switches is fixed and is larger than the resonant frequency of the resonant tank circuit 12. As shown in FIG. 8B, the three-level rectification DC/DC converter 1 further includes a control module 14b. The control module 14b is configured to acquire an input voltage signal Vin_FB, an output voltage signal Vo_FB and an output current signal Io_FB reflecting the input voltage Vin, the output voltage Vo and the output current Io respectively through detection, and to control the operation of all the primary and secondary switches. The control module 14b includes a regulator 141, and the regulator 141 generates a regulating signal according to the output voltage signal Vo_FB, the output current signal Io_FB, an output reference voltage Vo_ref, and an output reference current Io_ref. In this embodiment, the control module 14b further includes a PWM controller 144. The PWM controller 144 is coupled to the regulator 141, and generates the driving signals of all the primary and secondary switches according to the regulating signal.

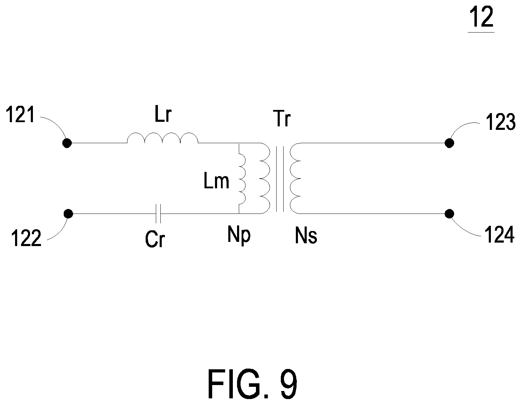

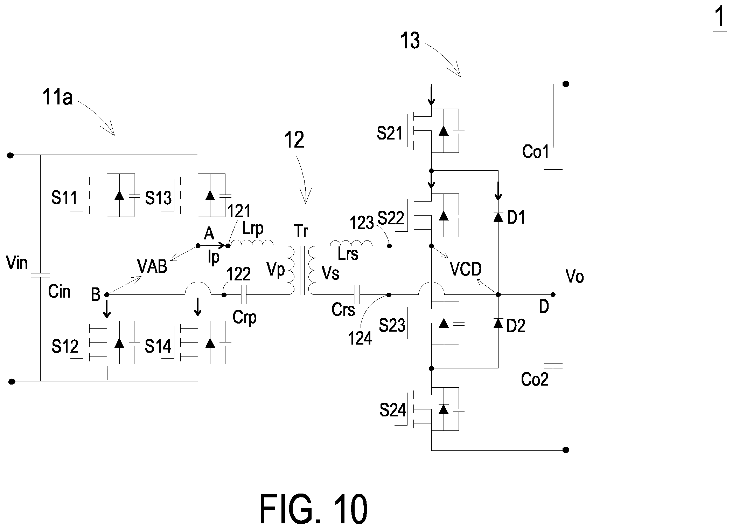

In addition, in the three-level rectification DC/DC converter 1 of the present disclosure, the resonant inductor Lr and the resonant capacitor Cr of the resonant tank circuit 12 have various kinds of actual implementations. FIG. 9 schematically shows a specific implementation of the resonant tank circuit 12. In the embodiment shown in FIG. 9, the resonant inductor Lr, the primary winding Np, and the resonant capacitor Cr are sequentially connected between the first primary terminal 121 and the second primary terminal 122 in series, but not limited thereto. For example, the resonant capacitor Cr may be connected in series between the secondary winding Ns and the second secondary terminal 124, and the resonant inductor Lr may be connected in series between the secondary winding Ns and the first secondary terminal 123. Further, as exemplified in FIG. 10, in an embodiment, the resonant inductor Lr includes a primary resonant inductor Lrp and a secondary resonant inductor Lrs, the primary resonant inductor Lrp is connected in series between the primary winding Np and the first primary terminal 121, and the secondary resonant inductor Lrs is connected in series between the secondary winding Ns and the first secondary terminal 123. In an embodiment, the resonant capacitor Cr includes a primary resonant capacitor Crp and a secondary resonant capacitor Crs, the primary resonant capacitor Crp is connected in series between the primary winding Np and the second primary terminal 122, and the secondary resonant capacitor Crs is connected in series between the secondary winding Ns and the second secondary terminal 124.

Moreover, in the three-level rectification DC/DC converter 1 of the present disclosure, the actual circuit topology of the primary circuit is not limited, and the primary circuit is for example but not limited to a full-bridge circuit, a half-bridge circuit, a serial-half-bridge circuit, a three-level circuit with a flying capacitor, or a three-level circuit with the clamped midpoint. Two kinds of actual circuit topologies of the primary circuit are exemplified as follows.

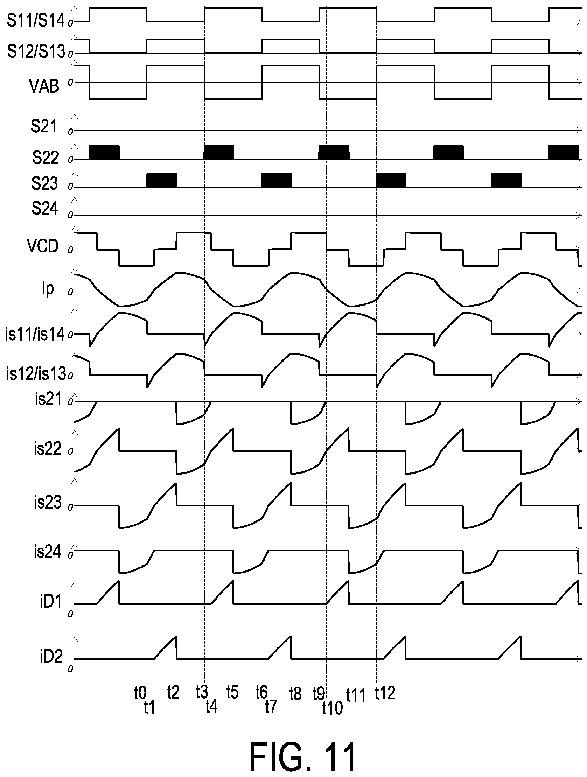

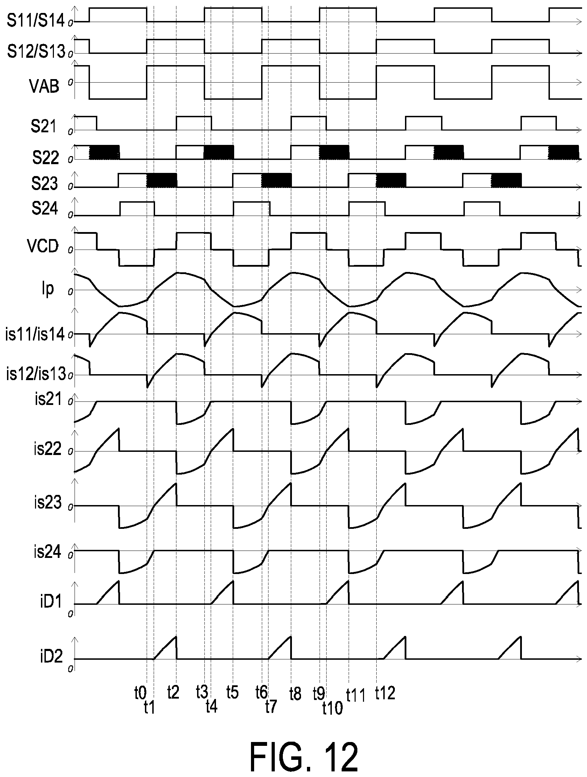

In an embodiment, as shown in FIG. 10, the primary circuit 11a is a full-bridge circuit, and the primary circuit 11a includes an input capacitor Cin, a first bridge arm, and a second bridge arm connected to each other in parallel. The voltage on the input capacitor Cin is the input voltage Vin. The first bridge arm includes a first primary switch S11 and a second primary switch S12 connected in series, and a node B between the first primary switch S11 and the second primary switch S12 is connected to the second primary terminal 122. The second bridge arm includes a third primary switch S13 and a fourth primary switch S14, and a node A between the third primary switch S13 and the fourth primary switch S14 is connected to the first primary terminal 121. All the primary switches in the primary circuit 11a can be turned on with zero voltage switching. FIG. 11 is a schematic oscillogram showing the key waveforms of the three-level rectification DC/DC converter of FIG. 10. FIG. 12 is a schematic oscillogram showing the key waveforms of the three-level rectification DC/DC converter of FIG. 10 while applying complete synchronous rectification to the secondary switches.

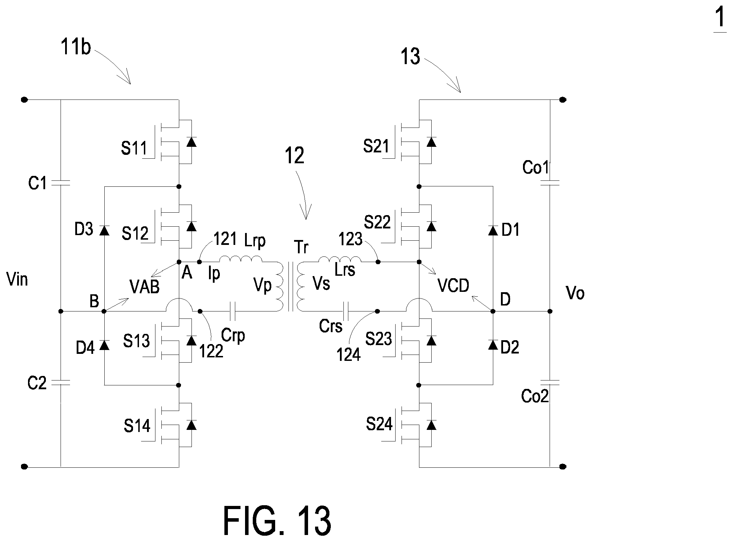

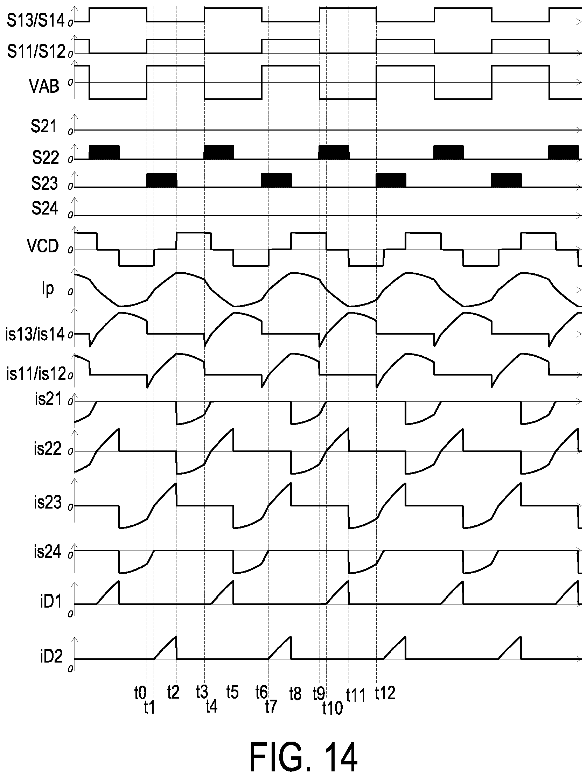

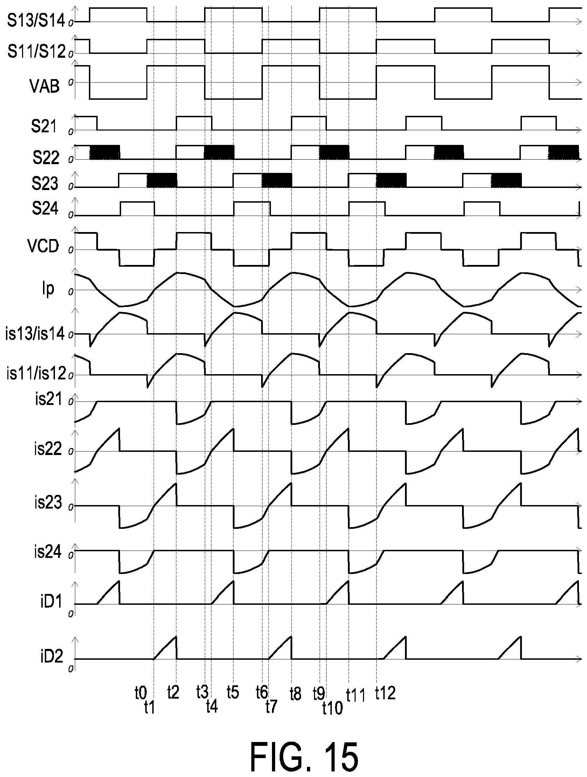

In an embodiment, as shown in FIG. 13, the primary circuit 11b is a three-level circuit with a clamped midpoint, and the primary circuit 11b includes two primary clamping switches D3 and D4, a first bridge arm, and a second bridge arm. The voltage between the two terminals of the first bridge arm is the input voltage Vin, and the two terminals of the first bridge arm are connected to two terminals of the second bridge arm respectively. The first bridge arm includes a first input capacitor C1 and a second input capacitor C2 connected in series. The second bridge arm includes a first primary switch S11, a second primary switch S12, a third primary switch S13, and a fourth primary switch S14 sequentially connected in series. The two primary clamping switches D3 and D4 are connected in series between a node between the first primary switch S11 and the second primary switch S12 and a node between the third primary switch S13 and the fourth primary switch S14. A node A between the second primary switch S12 and the third primary switch S13 is connected to the first primary terminal 121, and a node between the first input capacitor C1 and the second input capacitor C2 is connected to a node B between the two primary clamping switches D3 and D4 and the second primary terminal 122. All the primary switches in the primary circuit 11b can be turned on with zero voltage switching. FIG. 14 is a schematic oscillogram showing the key waveforms of the three-level rectification DC/DC converter of FIG. 13. FIG. 15 is a schematic oscillogram showing the key waveforms of the three-level rectification DC/DC converter of FIG. 13 while applying complete synchronous rectification to the secondary switches.

In summary, the present disclosure provides a three-level rectification DC/DC converter which has the characteristic of a resonant circuit and can meet the bidirectional work requirement. In addition, the three-level rectification DC/DC converter has the characteristic of storing energy through short-circuiting the secondary circuit thereof, thereby achieving the output with high voltage gain. Since the highest voltage on the secondary switch equals one-half of the output voltage, the secondary switch can be implemented by switch components with low withstand voltage, which makes the selection for switch components easier and reduces the cost. Moreover, through controlling the four secondary switches, the energy is stored in the resonant inductor during the operating process by the secondary circuit equivalent to be short-circuited, thereby achieving the high-gain voltage output.

## Claims

1. A DC/DC converter (1) with three-level rectification, comprising:
a primary circuit (11) receiving an input voltage (Vin) and comprising a plurality of primary switches;
a resonant tank circuit (12) comprising a resonant inductor (Lr), a resonant capacitor (Cr), and a transformer (Tr), wherein a first primary terminal (121) and a second primary terminal (122) of the resonant tank circuit (12) are coupled to the primary circuit (11), a primary winding (Np) of the transformer (Tr) is coupled between the first and second primary terminals (121, 122), a secondary winding (Ns) of the transformer (Tr) is coupled between a first secondary terminal (123) and a second secondary terminal (124) of the resonant tank circuit (12), a voltage between the first and second primary terminals (121, 122) is a first voltage (VAB), a voltage between the first and second secondary terminals (123, 124) is a second voltage (VCD); and
a secondary circuit (13) comprising two clamping switches (D1, D2), a switch bridge arm, and a capacitor bridge arm, wherein the switch bridge arm comprises a first secondary switch (S21), a second secondary switch (S22), a third secondary switch (S23), and a fourth secondary switch (S24) sequentially connected in series, the two clamping switches (D1, D2) are connected in series between a node between the first and second secondary switches (S21, S22) and a node between the third and fourth secondary switches (S23, S24), a node (C) between the second and third secondary switches (S22, S23) is connected to the first secondary terminal (123), the capacitor bridge arm comprises a first output capacitor (Co1) and a second output capacitor (Co2) connected in series, a node between the first and second output capacitors (Co1, Co2) is connected to a node (D) between the two clamping switches (D1, D2) and the second secondary terminal (124), two terminals of the capacitor bridge arm are connected to two terminals of the switch bridge arm, and a voltage between the two terminals of the capacitor bridge arm is an output voltage (Vo),
wherein the first voltage (VAB) is a square wave, **characterized in that**,
if the first and fourth secondary switches (S21, S24) are maintained in an off state during a diode rectification mode, the second secondary switch (S22) is switched from the off state to an on state at a falling edge in a period of the first voltage (VAB) and is in the on state for a preset time length after the falling edge, and the third secondary switch (S23) is switched from the off state to the on state at a rising edge in the period of the first voltage (VAB) and is in the on state for the preset time length after the rising edge.

2. The DC/DC converter (1) according to claim 1, wherein phases of the second and third secondary switches (S22, S23) are out of phase by 180 degrees with respect to each other.

3. The DC/DC converter (1) according to claim 1, wherein a switching frequency of the second and third secondary switches (S22, S23) is equal to a frequency of the first voltage (VAB).

4. The DC/DC converter (1) according to claim 1, wherein if the first and fourth secondary switches (S21, S24) are not maintained in an off state during a complete synchronous rectification mode, the first, second, third, and fourth secondary switches (S21, S22, S23, S24) are further in the on state during all durations within a duration of currents flowing reversely through the first, second, third, and fourth secondary switches (S21, S22, S23, S24) respectively, wherein the second secondary switch (S22) remains in the on state for the preset time length after the falling edge in the period of the first voltage (VAB), and the third secondary switch (S23) remains in the on state for the preset time length after the rising edge in the period of the first voltage (VAB).

5. The DC/DC converter (1) according to claim 4, wherein driving signals of the second and third secondary switches (S22, S23) are complementary.

6. The DC/DC converter (1) according to claim 1, wherein the preset time length is obtained based on the input voltage (Vin) and the output voltage (Vo).

7. The DC/DC converter (1) according to claim 1, wherein all the primary and secondary switches are turned on with zero voltage switching.

8. The DC/DC converter (1) according to claim 1, wherein the first voltage (VAB) is at a high level in one-half period and at a low level in the other half period.

9. The DC/DC converter (1) according to claim 1, wherein the first and fourth secondary switches (S21, S24) are active switches.

10. The DC/DC converter (1) according to claim 1, wherein the first and fourth secondary switches (S21, S24) are a first diode and a second diode respectively, an anode and a cathode of the first diode are coupled to the second secondary switch (S22) and the first output capacitor (Co1) respectively, and an anode and a cathode of the second diode are coupled to the second output capacitor (Co2) and the third secondary switch (S23) respectively.

11. The DC/DC converter (1) according to claim 1, wherein the two clamping switches (D1, D2) are active switches.

12. The DC/DC converter (1) according to claim 1, wherein the two clamping switches (D1, D2) are a third diode and a fourth diode, an anode and a cathode of the third diode are coupled a cathode of the fourth diode and a node between the first and second secondary switches (S21, S22) respectively, and an anode of the fourth diode is coupled to a node between the third and fourth secondary switches (S23, S24).

13. The DC/DC converter (1) according to claim 1, wherein the primary circuit (11a) comprises an input capacitor (Cin), a first bridge arm, and a second bridge arm connected to each other in parallel, a voltage on the input capacitor (Cin) is the input voltage (Vin), the first bridge arm comprises a first primary switch (S11) and a second primary switch (S12) connected in series, a node (B) between the first and second primary switches (S11, S12) is connected to the second primary terminal (122), the second bridge arm comprises a third primary switch (S13) and a fourth primary switch (S14), and a node (A) between the third and fourth primary switches (S13, S14) is connected to the first primary terminal (121).

14. The DC/DC converter (1) according to claim 1, wherein the primary circuit (11b) comprises two primary clamping switches (D3, D4), a first bridge arm, and a second bridge arm, a voltage between two terminals of the first bridge arm is the input voltage (Vin), the two terminals of the first bridge arm are connected to two terminals of the second bridge arm respectively, the first bridge arm comprises a first input capacitor (C1) and a second input capacitor (C2) connected in series, the second bridge arm comprises a first primary switch (S11), a second primary switch (S12), a third primary switch (S13), and a fourth primary switch (S14) sequentially connected in series, the two primary clamping switches (D3, D4) are connected in series between a node between the first and second primary switches (S11, S12) and a node between the third and fourth primary switches (S13, S14), a node (A) between the second and third primary switches (S12, S13) is connected to the first primary terminal (121), and a node between the first and second input capacitors (C1, C2) is connected to a node (B) between the two primary clamping switches (D3, D4) and the second primary terminal (122).

15. The DC/DC converter (1) according to claim 1, wherein in the resonant tank circuit (12), the resonant inductor (Lr), the primary winding (Np), and the resonant capacitor (Cr) are connected in series between the first and second primary terminals (121, 122).

16. The DC/DC converter (1) according to claim 1, further comprising a control module (14a, 14b), wherein the control module (14a, 14b) is configured to acquire an input voltage signal (Vin_FB), an output voltage signal (Vo_FB), and an output current signal (lo_FB) reflecting the input voltage (Vin), the output voltage (Vo), and an output current (lo) respectively through detection and to control the operation of all the primary and secondary switches, the control module (14a, 14b) comprises a regulator (141), and the regulator (141) generates a regulating signal according to the output voltage signal (Vo_FB), the output current signal (lo_FB), an output reference voltage (Vo_ref), and an output reference current (Io_ref).

17. The DC/DC converter (1) according to claim 16, wherein the control module (14a) further comprises a voltage-controlled oscillator (142) and a controller (143), the voltage-controlled oscillator (142) is coupled to the regulator (141) and generates a switching frequency (fs) of the plurality of primary switches according to the regulating signal, the controller (143) is coupled to the voltage-controlled oscillator (142), and the controller (143) generates an on-time (Ton) of all the secondary switches according to the input voltage signal (Vin_FB), the output voltage signal (Vo_FB) and the switching frequency (fs) of the plurality of primary switches.

18. The DC/DC converter (1) according to claim 16, wherein the control module (14b) further comprises a PWM controller (144) coupled to the regulator (141), and the PWM controller (144) generates driving signals of all the primary and secondary switches according to the regulating signal.

19. The DC/DC converter (1) according to claim 18, wherein a switching frequency (fs) of the plurality of primary switches is fixed and is larger than a resonant frequency of the resonant tank circuit (12).

## Patentansprüche

1. DC/DC-Wandler (1) mit dreistufiger Gleichrichtung, umfassend:
eine Primärschaltung (11), die eine Eingangsspannung (Vin) empfängt und eine Mehrzahl von Primärschalter umfasst;
eine Resonanzschwingschaltung (12), die einen Resonanzinduktor (Lr), einen Resonanzkondensator (Cr) und einen Transformator (Tr) umfasst, wobei ein erster Primäranschluss (121) und ein zweiter Primäranschluss (122) der Resonanzschwingschaltung (12) mit der Primärschaltung (11) gekoppelt sind, eine Primärwicklung (Np) des Transformators (Tr) zwischen dem ersten und dem zweiten Primäranschluss (121, 122) gekoppelt ist, eine Sekundärwicklung (Ns) des Transformators (Tr) zwischen einem ersten Sekundäranschluss (123) und einem zweiten Sekundäranschluss (124) des Resonanzschwingschaltung (12) gekoppelt ist, eine Spannung zwischen dem ersten und dem zweiten Primäranschluss (121, 122) eine erste Spannung (VAB) ist, eine Spannung zwischen dem ersten und dem zweiten Sekundäranschluss (123, 124) eine zweite Spannung (VCD) ist; und
eine Sekundärschaltung (13), die zwei Klemmschalter (D1, D2), einen Schalterbrückenzweig und einen Kondensatorbrückenzweig umfasst, wobei der Schalterbrückenzweig einen ersten Sekundärschalter (S21), einen zweiten Sekundärschalter (S22), einen dritten Sekundärschalter (S23) und einen vierten Sekundärschalter (S24) umfasst, die sequentiell in Reihe geschaltet sind, die beiden Klemmschalter (D1, D2) in Reihe zwischen einem Knoten zwischen dem ersten und dem zweiten Sekundärschalter (S21, S22) und einem Knoten zwischen dem dritten und dem vierten Sekundärschalter (S23, S24) geschaltet sind, ein Knoten (C) zwischen dem zweiten und dem dritten Sekundärschalter (S22, S23) mit dem ersten Sekundäranschluss (123) verbunden ist, der Kondensatorbrückenzweig einen ersten Ausgangskondensator (Co1) und einen zweiten Ausgangskondensator (Co2) umfasst, die in Reihe geschaltet sind, ein Knoten zwischen dem ersten und dem zweiten Ausgangskondensator (Co1, Co2) mit einem Knoten (D) zwischen den beiden Klemmschaltern (D1, D2) und dem zweiten Sekundäranschluss (124) verbunden ist, zwei Anschlüsse des Kondensatorbrückenzweigs mit zwei Anschlüssen des Schalterbrückenzweigs verbunden sind, und eine Spannung zwischen den beiden Anschlüssen des Kondensatorbrückenzweigs eine Ausgangsspannung (Vo) ist, wobei die erste Spannung (VAB) eine Rechteckwelle ist,
**dadurch gekennzeichnet, dass**,
wenn der erste und der vierte Sekundärschalter (S21, S24) während einer Diodengleichrichtungsbetriebsart in einem Aus-Zustand gehalten werden, der zweite Sekundärschalter (S22) an einer fallenden Flanke in einer Periode der ersten Spannung (VAB) von dem Aus-Zustand in einen Ein-Zustand geschaltet wird und sich nach der fallenden Flanke für eine vorbestimmte Zeitdauer in dem Ein-Zustand befindet, und der dritte Sekundärschalter (S23) an einer steigenden Flanke in der Periode der ersten Spannung (VAB) von dem Aus-Zustand in den Ein-Zustand geschaltet wird und sich nach der steigenden Flanke für die vorbestimmte Zeitdauer in dem Ein-Zustand befindet.

2. DC/DC-Wandler (1) nach Anspruch 1, wobei die Phasen des zweiten und des dritten Sekundärschalters (S22, S23) relativ zueinander um 180 Grad phasenversetzt sind.

3. DC/DC-Wandler (1) nach Anspruch 1, wobei eine Schaltfrequenz des zweiten und des dritten Sekundärschalters (S22, S23) gleich einer Frequenz der ersten Spannung (VAB) ist.

4. DC/DC-Wandler (1) nach Anspruch 1, wobei, wenn der erste und der vierte Sekundärschalter (S21, S24) während einer vollständigen synchronen Gleichrichtungsbetriebsart nicht in einem Aus-Zustand gehalten werden, sich der erste, der zweite, der dritte und der vierte Sekundärschalter (S21, S22, S23, S24) während aller Dauern in einer Dauer, in der Ströme in umgekehrter Richtung durch den ersten, den zweiten, den dritten bzw. den vierten Sekundärschalter (S21, S22, S23, S24) fließen, weiter in dem Aus-Zustand befinden, wobei der zweite Sekundärschalter (S22) nach der fallenden Flanke in der Periode der ersten Spannung (VAB) für die vorbestimmte Zeitdauer in dem Ein-Zustand verbleibt, und der dritte Sekundärschalter (S23) nach der steigenden Flanke in der Periode der ersten Spannung (VAB) für die vorbestimmte Zeitdauer in dem Ein-Zustand verbleibt.

5. DC/DC-Wandler (1) nach Anspruch 4, wobei die Steuersignale des zweiten und des dritten Sekundärschalters (S22, S23) komplementär sind.

6. DC/DC-Wandler (1) nach Anspruch 1, wobei die vorbestimmte Zeitdauer basierend auf der Eingangsspannung (Vin) und der Ausgangsspannung (Vo) ermittelt wird.

7. DC/DC-Wandler (1) nach Anspruch 1, wobei alle Primär- und Sekundärschalter mit Nullspannungsschaltung eingeschaltet werden.

8. DC/DC-Wandler (1) nach Anspruch 1, wobei die erste Spannung (VAB) in einer Halbperiode auf einem hohen Pegel und in der anderen Halbperiode auf einem niedrigen Pegel liegt.

9. DC/DC-Wandler (1) nach Anspruch 1, wobei der erste und der vierte Sekundärschalter (S21, S24) aktive Schalter sind.

10. DC/DC-Wandler (1) nach Anspruch 1, wobei der erste und der vierte Sekundärschalter (S21, S24) eine erste Diode bzw. eine zweite Diode ist, wobei eine Anode und eine Kathode der ersten Diode mit dem zweiten Sekundärschalter (S22) bzw. mit dem ersten Ausgangskondensator (Co1) gekoppelt sind, und eine Anode und eine Kathode der zweiten Diode mit dem zweiten Ausgangskondensator (Co2) bzw. mit dritten Sekundärschalter (S23) gekoppelt sind.

11. DC/DC-Wandler (1) nach Anspruch 1, wobei die beiden Klemmschalter (D1, D2) aktive Schalter sind.

12. DC/DC-Wandler (1) nach Anspruch 1, wobei die beiden Klemmschalter (D1, D2) eine dritte Diode und eine vierte Diode sind, eine Anode und eine Kathode der dritten Diode mit einer Kathode der vierten Diode bzw. mit einem Knoten zwischen dem ersten und dem zweiten Sekundärschalter (S21, S22) gekoppelt sind, und eine Anode der vierten Diode mit einem Knoten zwischen dem dritten und dem vierten Sekundärschalter (S23, S24) gekoppelt ist.

13. DC/DC-Wandler (1) nach Anspruch 1, wobei die Primärschaltung (11a) einen Eingangskondensator (Cin), einen ersten Brückenzweig und einen zweiten Brückenzweig umfasst, die parallel miteinander verbunden sind, eine Spannung an dem Eingangskondensator (Cin) die Eingangsspannung (Vin) ist, der erste Brückenzweig einen ersten Primärschalter (S11) und einen zweiten Primärschalter (S12) umfasst, die in Reihe geschaltet sind, ein Knoten (B) zwischen dem ersten und dem zweiten Primärschalter (S11, S12) mit dem zweiten Primäranschluss (122) verbunden ist, der zweite Brückenzweig einen dritten Primärschalter (S13) und einen vierten Primärschalter (S14) umfasst, und ein Knoten (A) zwischen dem dritten und dem vierten Primärschalter (S13, S14) mit dem ersten Primäranschluss (121) verbunden ist.

14. DC/DC-Wandler (1) nach Anspruch 1, wobei die Primärschaltung (11b) zwei Primärklemmschalter (D3, D4), einen ersten Brückenzweig und einen zweiten Brückenzweig umfasst, eine Spannung zwischen zwei Anschlüssen des ersten Brückenzweigs die Eingangsspannung (Vin) ist, die beiden Anschlüsse des ersten Brückenzweigs jeweils mit zwei Anschlüssen des zweiten Brückenzweigs verbunden sind, der erste Brückenzweig einen ersten Eingangskondensator (C1) und einen zweiten Eingangskondensator (C2) umfasst, die in Reihe geschaltet sind, der zweite Brückenzweig einen ersten Primärschalter (S11), einen zweiten Primärschalter (S12), einen dritten Primärschalter (S13) und einen vierten Primärschalter (S14) umfasst, die sequentiell in Reihe geschaltet sind, die beiden Primärklemmschalter (D3, D4) in Reihe zwischen einem Knoten zwischen dem ersten und dem zweiten Primärschalter (S11, S12) und einem Knoten zwischen dem dritten und dem vierten Primärschalter (S13, S14) geschaltet sind, ein Knoten (A) zwischen dem zweiten und dem dritten Primärschalter (S12, S13) mit dem ersten Primäranschluss (121) verbunden ist, und ein Knoten zwischen dem ersten und dem zweiten Eingangskondensator (C1, C2) mit einem Knoten (B) zwischen den beiden Primärklemmschaltern (D3, D4) und dem zweiten Primäranschluss (122) verbunden ist.

15. DC/DC-Wandler (1) nach Anspruch 1, wobei in der Resonanzschwingschaltung (12), der Resonanzinduktor (Lr), die Primärwicklung (Np) und der Resonanzkondensator (Cr) in Reihe zwischen dem ersten und dem zweiten Primäranschluss (121, 122) geschaltet sind.

16. DC/DC-Wandler (1) nach Anspruch 1, ferner umfassend ein Steuermodul (14a, 14b), wobei das Steuermodul (14a, 14b) konfiguriert ist, um ein Eingangsspannungssignal (Vin_FB), ein Ausgangsspannungssignal (Vo_FB) und ein Ausgangsstromsignal (Io_FB) zu erfassen, die die Eingangsspannung (Vin), die Ausgangsspannung (Vo) bzw. einen Ausgangsstrom (Io) durch Erfassung wiedergeben, und den Betrieb aller Primär- und Sekundärschalter zu steuern, das Steuermodul (14a, 14b) einen Regler (141) umfasst, und der Regler (141) ein Regelsignal entsprechend dem Ausgangsspannungssignal (Vo_FB), dem Ausgangsstromsignal (Io_FB), einer Ausgangsreferenzspannung (Vo_ref) und einem Ausgangsreferenzstrom (Io_ref) erzeugt.

17. DC/DC-Wandler (1) nach Anspruch 16, wobei das Steuermodul (14a) ferner einen spannungsgesteuerten Oszillator (142) und einen Controller (143) umfasst, der spannungsgesteuerte Oszillator (142) mit dem Regler (141) gekoppelt ist und entsprechend dem Regelsignal eine Schaltfrequenz (fs) der Mehrzahl von Primärschaltern erzeugt, der Controller (143) mit dem spannungsgesteuerten Oszillator (142) gekoppelt ist, und der Controller (143) eine Ein-Zeit (Ton) aller Sekundärschalter entsprechend dem Eingangsspannungssignal (Vin_FB), dem Ausgangsspannungssignal (Vo_FB) und der Schaltfrequenz (fs) der Mehrzahl von Primärschaltern erzeugt.

18. DC/DC-Wandler (1) nach Anspruch 16, wobei das Steuermodul (14b) ferner einen PWM-Controller (144) umfasst, der mit dem Regler (141) gekoppelt ist, und der PWM-Controller (144) Steuersignale für alle Primär- und Sekundärschalter entsprechend dem Regelsignal erzeugt.

19. DC/DC-Wandler (1) nach Anspruch 18, wobei eine Schaltfrequenz (fs) der Mehrzahl von Primärschaltern fest eingestellt und größer ist als eine Resonanzfrequenz des Resonanzschwingschaltung (12).

## Revendications

1. Convertisseur CC/CC (1) avec redressement à trois niveaux, comprenant:
un circuit primaire (11) recevant une tension d'entrée (Vin) et comprenant une pluralité d'interrupteurs primaires;
un circuit bouchon résonant (12) comprenant un inducteur résonant (Lr), un condensateur résonant (Cr), et un transformateur (Tr), dans lequel une première borne primaire (121) et une seconde borne primaire (122) du circuit bouchon résonant (12) sont couplées au circuit primaire (11), un enroulement primaire (Np) du transformateur (Tr) est couplé entre les première et seconde bornes primaires (121, 122), un enroulement secondaire (Ns) du transformateur (Tr) est couplé entre une première borne secondaire (123) et une seconde borne secondaire (124) du circuit bouchon résonant (12), une tension entre les première et seconde bornes primaires (121, 122) est une première tension (VAB), une tension entre les première et seconde bornes secondaires (123, 124) est une seconde tension (VCD); et
un circuit secondaire (13) comprenant deux interrupteurs de verrouillage (D1, D2), une branche interrupteur de pont, et une branche condensateur de pont, dans lequel la branche interrupteur de pont comprend un premier interrupteur secondaire (S21), un second interrupteur secondaire (S22), un troisième interrupteur secondaire (S23), et un quatrième interrupteur secondaire (S24) connectés séquentiellement en série, les deux interrupteurs de verrouillage (D1, D2) sont connectés en série entre un nœud entre les premier et second interrupteurs secondaires (S21, S22) et un nœud entre les troisième et quatrième interrupteurs secondaires (S23, S24), un nœud (C) entre les second et troisième interrupteurs secondaires (S22, S23) est connecté à la première borne secondaire (123), la branche condensateur de pont comprend un premier condensateur de sortie (Co1) et une second condensateur de sortie (Co2) connectés en série, un nœud entre les premier et second condensateurs de sortie (Co1, Co2) est connecté à un nœud (D) entre les deux interrupteurs de verrouillage (D1, D2) et la seconde borne secondaire (124), deux bornes de la branche condensateur de pont sont connectées à deux bornes de la branche interrupteur de pont, et une tension entre les deux bornes de la branche condensateur de pont est une tension de sortie (Vo), dans lequel la première tension (VAB) est une onde carrée,
**caractérisé en ce que**,
si les premier et quatrième interrupteurs secondaires (S21, S24) sont maintenus dans un état off pendant un mode de redressement par diode, le second interrupteur secondaire (S22) est commuté de l'état off vers un état on en un bord tombant dans une période de la première tension (VAB) et est dans l'état on pour une durée préétablie après le bord tombant, et le troisième interrupteur secondaire (S23) est commuté de l'état off à l'état on en un bord montant dans la période de la première tension (VAB) et est dans l'état on pour la durée préétablie après le bord montant.

2. Convertisseur CC/CC (1) selon la revendication 1, dans lequel des phases des second et troisième interrupteurs secondaires (S22, S23) sont déphasées de 180 degrés l'une de l'autre.

3. Convertisseur CC/CC (1) selon la revendication 1, dans lequel une fréquence de commutation des second et troisième interrupteurs secondaires (S22, S23) est égale à une fréquence de la première tension (VAB).

4. Convertisseur CC/CC (1) selon la revendication 1, dans lequel si les premier et quatrième interrupteurs secondaires (S21, S24) ne sont pas maintenus dans un état off pendant un mode de redressement synchrone complet, les premier, second, troisième, et quatrième interrupteurs secondaires (S21, S22, S23, S24) sont encore dans l'état on pendant toutes les durées dans une durée de courants s'écoulant inversement à travers les premier, second, troisième, et quatrième interrupteurs secondaires (S21, S22, S23, S24) respectivement, dans lequel le second interrupteur secondaire (S22) reste dans l'état on pendant la durée préétablie après le bord tombant dans la période de la première tension (VAB), et le troisième interrupteur secondaire (S23) reste dans l'état on pendant la durée préétablie après le bord montant dans la période de la première tension (VAB).

5. Convertisseur CC/CC (1) selon la revendication 4, dans lequel des signaux de commande des second et troisième interrupteurs secondaires (S22, S23) sont complémentaires.

6. Convertisseur CC/CC (1) selon la revendication 1, dans lequel la durée préétablie est obtenue en se basant sur la tension d'entrée (Vin) et la tension de sortie (Vo).

7. Convertisseur CC/CC (1) selon la revendication 1, dans lequel tous les interrupteurs primaires et secondaires sont mis sur on avec une commutation sans tension.

8. Convertisseur CC/CC (1) selon la revendication 1, dans lequel la première tension (VAB) est à un haut niveau dans une demi-période et à un bas niveau dans l'autre demi-période.

9. Convertisseur CC/CC (1) selon la revendication 1, dans lequel les premier et quatrième interrupteurs secondaires (S21, S24) sont des interrupteurs actifs.

10. Convertisseur CC/CC (1) selon la revendication 1, dans lequel les premier et quatrième interrupteurs secondaires (S21, S24) sont respectivement une première diode et une seconde diode, une anode et une cathode de la première diode sont couplées au second interrupteur secondaire (S22) et au premier condensateur de sortie (Co1) respectivement, et une anode et une cathode de la seconde diode sont couplées respectivement au second condensateur de sortie (Co2) et au troisième interrupteur secondaire (S23).

11. Convertisseur CC/CC (1) selon la revendication 1, dans lequel les deux interrupteurs de verrouillage (D1, D2) sont des interrupteurs actifs.

12. Convertisseur CC/CC (1) selon la revendication 1, dans lequel les deux interrupteurs de verrouillage (D1, D2) sont une troisième diode et une quatrième diode, une anode et une cathode de la troisième diode sont couplées respectivement à une cathode de la quatrième diode et à un nœud entre les premier et second interrupteurs secondaires (S21, S22), et une anode de la quatrième diode est couplée à un nœud entre les troisième et quatrième interrupteurs secondaires (S23, S24).

13. Convertisseur CC/CC (1) selon la revendication 1, dans lequel le circuit primaire (11a) comprend un condensateur d'entrée (Cin), une première branche de pont, et une seconde branche de pont connectés ensemble en parallèle, une tension sur le condensateur d'entrée (Cin) est la tension d'entrée (Vin), la première branche de pont comprend un premier interrupteur primaire (S11) et un second interrupteur primaire (S12) connectés en série, un nœud (B) entre les premier et second interrupteurs primaires (S11, S12) est connecté à la seconde borne primaire (122), la seconde branche de pont comprend un troisième interrupteur primaire (S13) et un quatrième interrupteur primaire (S14), et un nœud (A) entre les troisième et quatrième interrupteurs primaires (S13, S14) est connecté à la première borne primaire (121).

14. Convertisseur CC/CC (1) selon la revendication 1, dans lequel le circuit primaire (11B) comprend deux interrupteurs de verrouillage primaires (D3, D4), une première branche de pont, et une seconde branche de pont, une tension entre deux bornes de la première branche de pont est la tension d'entrée (Vin), les deux bornes de la première branche de pont sont connectées à deux bornes de la seconde branche de pont respectivement, la première branche de pont comprend un premier condensateur d'entrée (C1) et un second condensateur d'entrée (C2) connectés en série, la seconde branche de pont comprend un premier interrupteur primaire (S11), un second interrupteur primaire (S12), un troisième interrupteur primaire (S13), et un quatrième interrupteur primaire (S14) connectés séquentiellement en série, les deux interrupteurs de verrouillage primaires (D3, D4) sont connectés en série entre un nœud entre les premier et second interrupteurs primaires (S11, S12) et un nœud entre les troisième et quatrième interrupteurs primaires (S13, S14), un nœud (A) entre les second et troisième interrupteurs primaires (S12, S13) est connecté à la première borne primaire (121), et un nœud entre les premier et second condensateurs (C1, C2) est connecté à un nœud (B) entre les deux interrupteurs de verrouillage primaires (D3, D4) et la seconde borne primaire (122).

15. Convertisseur CC/CC (1) selon la revendication 1, dans lequel dans le circuit bouchon résonant (12), l'inducteur résonant (Lr), l'enroulement primaire (Np), et le condensateur résonant (Cr) sont connectés en série entre les première et seconde bornes primaires (121, 122).

16. Convertisseur CC/CC (1) selon la revendication 1, comprenant en outre un module de commande (14a, 14b), dans lequel le module de commande (14a, 14b) est configuré pour acquérir un signal de tension d'entrée (Vin_FB), un signal de tension de sortie (Vo_FB), et un signal de courant de sortie (Io_FB) réfléchissant respectivement la tension d'entrée (Vin), la tension de sortie (Vo) et un courant de sortie (Io) par détection et pour commander le fonctionnement de tous les interrupteurs primaires et secondaires, le module de commande (14a, 14b) comprend un régulateur (141), et le régulateur (141) génère un signal de régulation selon le signal de tension de sortie (Vo_FB), le signal de courant de sortie (Io_FB), une tension de référence de sortie (Vo_ref), et un courant de référence de sortie (Io_ref).

17. Convertisseur CC/CC (1) selon la revendication 16, dans lequel le module de commande (14a) comprend en outre un oscillateur commandé en tension (142), et une commande (143), l'oscillateur commandé en tension (142) est couplé au régulateur (141) et génère une fréquence de commutation (fs) de la pluralité d'interrupteurs primaires selon le signal de régulation, la commande (143) est couplée à l'oscillateur commandé en tension (142), et la commande (143) génère un temps on (Ton) de tous les interrupteurs secondaires selon le signal de tension d'entrée (Vin_FB), le signal de tension de sortie (Vo_FB) et la fréquence de commutation (fs) de la pluralité d'interrupteurs primaires.

18. Convertisseur CC/CC (1) selon la revendication 16, dans lequel le module de commande (14b) comprend en outre une commande PWM (144) couplée au régulateur (141), et la commande PWM (144) génère des signaux de commande de tous les interrupteurs primaires et secondaires selon le signal de régulation.

19. Convertisseur CC/CC (1) selon la revendication 18, dans lequel une fréquence de commutation (fs) de la pluralité d'interrupteurs primaires est fixée et est supérieure à une fréquence de résonance du circuit bouchon résonant (12).
